# EUROPEAN PATENT APPLICATION

(11) **EP 4 498 774 A1**
(43) Date of publication of application: **29.01.2025**
(21) Application number: 23773534.5
(22) Date of filing: 22.02.2023
(51) Int. Cl.: H05K 7/20

(54) **CONTROLLER**

(30) Priority: 23.03.2022 CN 202220652598 U
(71) Applicant: Nio Technology (Anhui) Co., Ltd, Hefei City, Anhui 230601 (CN)
(72) Inventor: LIU, Shuaijie, Shanghai 201804 (CN); SHI, Jiepei, Shanghai 201804 (CN); CAI, Yunyue, Shanghai 201804 (CN)
(74) Representative: Vossius & Partner Patentanwälte Rechtsanwälte mbB
(86) International application number: PCT/CN2023/077680
(87) International publication number: WO 2023/179283

(57) **Abstract**

The disclosure relates to the technical field of controllers, aiming to solve the problem that an existing large assembly tolerance between a chip in a PCBA module and a heat dissipation structure affects the heat dissipation effect of the chip. The disclosure provides a controller, including a body and a PCBA module, the PCBA module including a PCB and a chip, a heat conducting member being provided between the chip and the body, an elastic member being provided between the heat conducting member and the body, the heat conducting member being connected to a heat dissipating member, the chip abutting against a first side of the heat conducting member, and the elastic member abutting against the body at one end and abutting against a second side of the heat conducting member at the other end. Under a rebound force of the elastic member, the heat conducting member is always in tight, stable and full contact with the chip to allow heat on the chip to be transferred to the heat conducting member and effectively dissipated by the heat dissipating member, such that the occurrence that a large assembly tolerance between the heat conducting member and the chip affects the heat dissipation effect of the chip is avoided, thereby improving the heat dissipation efficiency of the chip, and enabling the chip to be operated and used stably for a long time.

## Description

The disclosure claims the priority to Chinese Patent Application No. CN 202220652598.2, filed on March 23, 2022, and entitled "CONTROLLER", which is incorporated herein by reference in its entirety.

### Technical Field

The disclosure relates to the technical field of controllers, and in particular provides a controller.

### Background Art

As an important electronic control unit of a vehicle, a vehicle controller plays an important role in normal and safe driving of the vehicle. An existing controller on the vehicle includes a plurality of PCBA modules and heat dissipation structures, and when the controller is in operation, devices such as chips in the PCBA modules generate heat, causing an ambient temperature inside the controller to increase, which affects the performance of the chips. Since the chips in the PCBA modules have various heights, in order to transfer the heat from the chips to the heat dissipation structures, the commonly used method at present is to add a heat conducting pad between each chip and each heat dissipation structure to enable the heat from the chips having various heights to be transferred to the same heat dissipation structure for heat dissipation. However, in practical applications, due to the limitations of manufacturing accuracy, assembly accuracy, and other factors, an assembly tolerance between the heat conducting pad and the chip is large, causing a poor contact between the chip and the heat conducting pad, thereby affecting the heat dissipation effect of the chip to a certain extent.

Accordingly, there is a need in the art for a new controller to solve the problems existing in the prior art.

### Summary

The disclosure aims to solve the above technical problem, that is, to solve the problem that an existing large assembly tolerance between a chip in a PCBA module and a heat dissipation structure affects the heat dissipation effect of the chip.

The disclosure provides a controller including a body and a PCBA module arranged on the body, the PCBA module including a PCB and a chip fixed on a surface of the PCB, a heat conducting member capable of moving in a direction perpendicular to the surface of the PCB being provided between the chip and the body, an elastic member being provided between the heat conducting member and the body, the heat conducting member being connected to a heat dissipating member, and in an installed state, the chip abutting against a first side of the heat conducting member, and the elastic member abutting against the body at one end and abutting against a second side of the heat conducting member at the other end.

With the above arrangement, the chip is fixed on the PCB, the heat conducting member capable of moving in a direction perpendicular to the surface of the PCB is provided between the chip and the body, and the elastic member is provided between the heat conducting member and the body. In an installed state, the elastic member abuts against the body at one end and abuts against the heat conducting member at the other end, and under the action of a rebound force of the elastic member, the heat conducting member can always be in tight, stable and full contact with the chip to allow heat generated on the chip to be transferred to the heat conducting member and effectively dissipated by the heat dissipating member connected to the heat conducting member, such that the occurrence that the large assembly tolerance between the heat conducting member and the chip affects the heat dissipation effect of the chip is avoided, and a pressure on the chip due to the large tolerance can also be reduced, thereby improving the heat dissipation efficiency of the chip, prolonging the service life of the chip, and enabling the chip to be operated and used stably for a long time.

In a preferred technical solution of the controller, the elastic member is a plurality of springs uniformly arranged between the heat conducting member and the body.

With the above arrangement, the plurality of springs are uniformly arranged between the heat conducting member and the body to provide a stable and strong support to the heat conducting member, such that the heat conducting member can be always in tight contact with the chip for effective heat dissipation, and when the PCBA module is subjected to vibration, the plurality of springs can provide a good damping effect, such that the PCB and chip are not easily damaged.

In a preferred technical solution of the controller, a layer of heat conducting material is provided between the first side of the heat conducting member and the chip.

With the above arrangement, the layer of heat conducting material between the first side of the heat conducting member and the chip can be used to further dissipate heat from the PCB and the chip to increase a transfer speed of heat from the chip, thereby avoiding the occurrence of damage to the PCB and the chip due to overheating, and enabling the chip on the PCB to be operated and used stably for a long time.

In a preferred technical solution of the controller, the elastic member is a bellows.

In a preferred technical solution of the controller, a cooling chamber is provided inside the body, the body is provided with an inlet and an outlet that are in communication with the cooling chamber, and the inlet, the cooling chamber, and the outlet form a cooling channel for circulation of a cooling liquid.

With the above arrangement, the inlet, the cooling chamber, and the outlet together form the cooling channel for the circulation of the cooling liquid, the cooling liquid has the largest heat capacity and the best heat dissipation effect, and the circulation of the cooling liquid can further accelerate the heat transfer in the cooling chamber, thereby further increasing a dissipation speed of heat from the chip.

In a preferred technical solution of the controller, a heat conducting spacer is provided inside the cooling chamber.

With the above arrangement, the transfer speed of heat can be increased by means of the heat conducting spacer inside the cooling chamber, thereby further improving the heat dissipation efficiency.

In a preferred technical solution of the controller, the heat dissipating member includes a heat pipe.

In a preferred technical solution of the controller, the heat pipe has one side connected to the heat conducting member and the other side abutting against the body.

With the above arrangement, the installation reliability and heat dissipation stability of the heat pipe are improved.

In a preferred technical solution of the controller, the heat pipe is annular, and one side of the heat pipe is welded to the second side of the heat conducting member, and a part of the other side of the heat pipe is welded to the body.

With the above arrangement, the heat pipe is configured to be annular, and one side of the heat pipe is welded to the heat conducting member, and a part of the other side of the heat pipe is welded to the body, such that a contact area of the heat pipe with the heat conducting member and the body can be increased, thereby increasing the heat dissipation speed, and a part of the heat pipe is welded to the body, such that a part of the heat pipe remains a non-welded area, thereby facilitating the movement of the heat conducting member.

In a preferred technical solution of the controller, a guide structure is provided on the body and is configured to define a direction of movement of the heat conducting member.

With the above arrangement, the connection stability between the heat conducting member and the body can be improved by means of the guide structure, and the tight fit between the heat conducting member and the chip can always be ensured.

### Brief Description of the Drawings

Preferred implementations of the disclosure are described below with reference to the accompanying drawings, in which:
FIG. 1 is a schematic structural diagram of a controller according to an embodiment of the disclosure;
FIG. 2 is a schematic structural diagram of a heat conducting member according to an embodiment of the disclosure;
FIG. 3 is a first exploded view of a controller according to an embodiment of the disclosure;
FIG. 4 is a second exploded view of a controller according to an embodiment of the disclosure; and
FIG. 5 is a cross-sectional view of a controller according to an embodiment of the disclosure.

### List of reference signs:

1. Body; 2. PCBA module; 20. Intermediate plate; 21. PCB; 22. Chip; 23. Heat conducting member; 24. Elastic member; 25. Heat dissipating member; 26. Guide member; 3. Cooling chamber; 31. Inlet; 32. Outlet; 33. Heat conducting spacer.

### Detailed Description of Embodiments

Preferred implementations of the disclosure are described below with reference to the accompanying drawings. Those skilled in the art should understand that these implementations are merely used to explain the technical principles of the disclosure, and are not intended to limit the scope of protection of the disclosure.

It should be noted that, in the description of the disclosure, the terms that indicate the direction or positional relationship, such as "upper" and "inner", are based on the direction or positional relationship shown in the accompanying drawings, which is merely for ease of description instead of indicating or implying that a device or element must have a particular orientation and be constructed and operated in a particular orientation, and therefore, should not be construed as limiting the disclosure. In addition, the terms "first" and "second" are used for descriptive purposes only, and cannot be construed as indicating or implying relative importance.

In addition, it should also be noted that, in the description of the disclosure, the terms "dispose", "mount" and "connect" should be interpreted in a broad sense unless explicitly defined and limited otherwise. For example, a connection may be a fastened connection, a detachable connection, or an integral connection; or may be a direct connection, an indirect connection by means of an intermediary, or internal communication between two elements. For those skilled in the art, the specific meanings of the foregoing terms in the disclosure can be interpreted according to a specific situation.

In view of the problem mentioned in the background art that an existing large assembly tolerance between a chip in a PCBA module and a heat dissipation structure affects the heat dissipation effect of the chip, the disclosure provides a controller, which is intended to enable a heat conducting member to be always in tight, stable and full contact with a chip by means of a rebound force of an elastic member, so as to allow heat generated by the chip to be transferred to the heat conducting member and a heat dissipating member for effective heat dissipation, thereby improving the heat dissipation efficiency of the chip, prolonging the service life of the chip, and enabling the chip to be operated and used stably for a long time.

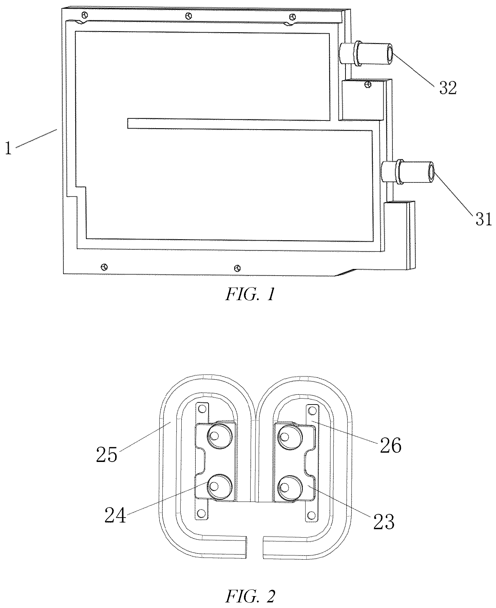

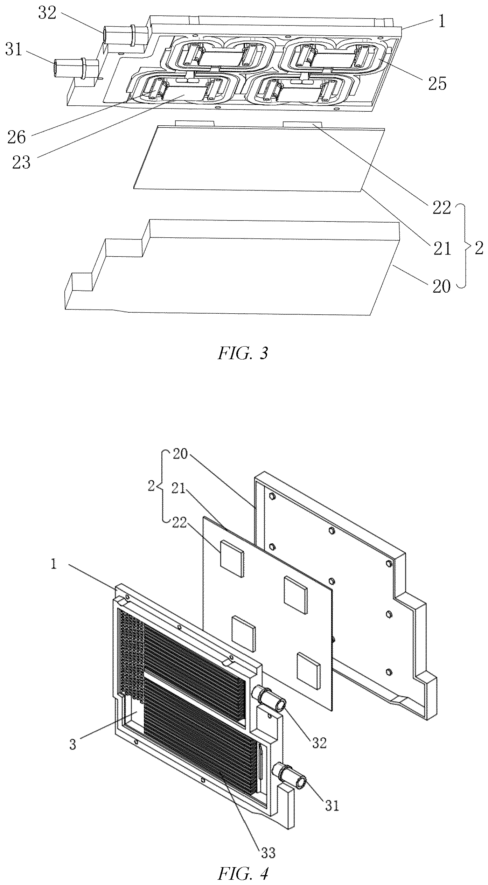

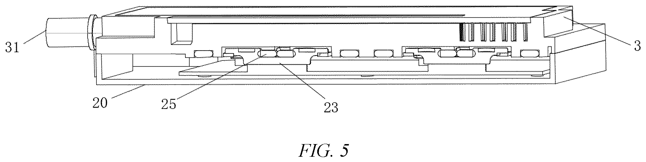

The controller of the disclosure is described in detail below with reference to FIGS. 1 to 5. FIG. 1 is a schematic structural diagram of a controller according to an embodiment of the disclosure; FIG. 2 is a schematic structural diagram of a heat conducting member according to an embodiment of the disclosure; FIG. 3 is a first exploded view of a controller according to an embodiment of the disclosure; FIG. 4 is a second exploded view of a controller according to an embodiment of the disclosure; and FIG. 5 is a cross-sectional view of a controller according to an embodiment of the disclosure.

Specifically, as shown in FIGS. 1-4, the controller includes a body 1 and a PCBA module 2 arranged on the body 1. The PCBA module 2 includes an intermediate plate 20 and a PCB 21 fixed on a surface of the intermediate plate 20. Four chips 22 are fixed on the PCB 21, and a heat conducting member 23 capable of moving in a direction perpendicular to a surface of the PCB 21 is provided between each of the chips 22 and the body 1. In practical applications, the number of chips 22 can be flexibly adjusted by those skilled in the art according to requirements of use.

The heat conducting member 23 is a heat conducting plate made of a metal material. Silver having a high heat conduction coefficient may be selected as the material of the heat conducting plate, or aluminum alloy having a high strength may be selected as the material of the heat conducting plate. It should be noted that the above configuration of the heat conducting member 23 is merely an exemplary configuration and does not limit the scope of protection of the disclosure. In practical applications, the shape and material of the heat conducting member 23 can be flexibly adjusted, as long as the heat conducting member fits the shape of the chip 22 while the heat dissipation performance is ensured.

Referring to FIG. 2, an elastic member 24 is provided between the heat conducting member 23 and the body 1. Springs are selected as the elastic member 24, and the springs are made of an insulating material, or stainless steel or other materials suitable for making springs. Four springs are provided and are uniformly arranged in a 2 × 2 array on the heat conducting member 23, and in an installed state, each of the springs abuts against the body 1 at one end and abuts against the heat conducting member 23 at the other end. It should be noted that the above arrangement is merely an exemplary arrangement and does not limit the scope of protection of the disclosure. In practical applications, features such as the number and the position of the springs can be flexibly adjusted. For example, six springs may be provided and are arranged in a 2 × 3 array on the heat conducting member 23.

Referring to FIGS. 3 to 5, the heat conducting member 23 is connected to a heat dissipating member 25, and the heat dissipating member 25 is a heat pipe which is annular. The heat pipe has one side connected to the heat conducting member 23 and the other side abutting against the body 1. The heat pipe may be connected to the heat conducting member 23 and the body 1 by means of welding or bonding. Specifically, one side of the annular heat pipe is fixed to the heat conducting member 23 by means of reflow soldering, and a part of the other side of the heat pipe is fixed to the body 1 by means of reflow soldering so as to remain the flexibility of the heat pipe.

A layer of heat conducting material is provided between the chip 22 and a first side of the heat conducting member 23, and may be made of a heat dissipating material such as a heat conducting silicone grease or a heat conducting gel. The heat conducting silicone grease is applied on a surface of the chip 22, or a compressible heat conducting film having a thickness of about 1 mm is provided on the surface of the chip 22. The heat conducting grease may also be applied on the first side of the heat conducting member 23.

Referring to FIG. 2, a guide structure 26 for defining a direction of movement of the heat conducting member 23 is provided on the body 1, and the guide structure 26 can fix the heat conducting member 23 to the body 1 by means of welding, or can fix the heat conducting member 23 to the body 1 by means of screwing.

Referring to FIG. 5, a cooling chamber 3 is provided inside the body 1, and the body 1 is provided with an inlet 31 and an outlet 32 that are in communication with the cooling chamber 3. The inlet 31, the cooling chamber 3, and the outlet 32 form a cooling channel for circulation of a cooling liquid, and the cooling channel is a planar circuit type cooling channel. The cooling liquid may be water or a mixture of water and alcohol. The outlet 32 is arranged close to the inlet 31, such that the overall flow direction of the cooling liquid tends to be the same as the trend of the cooling chamber 3, achieving relatively uniform cooling. It should be noted that the above specific positional arrangement of the inlet 31 and the outlet 32 is merely an exemplary arrangement, and the specific positions of the inlet 31 and the outlet 32 can be flexibly adjusted according to practical applications, as long as the circulation of the cooling liquid is facilitated.

A heat conducting spacer 33 is provided inside the cooling chamber 3. The heat conducting spacer 33 may be made of a material having a good heat conductivity, such as beryllium copper alloy. The cooling liquid is in direct contact with the heat conducting spacer 33 to enable heat to be transferred quickly, thereby improving the heat dissipation efficiency.

Specifically, the intermediate plate 20, and the PCB 21 and the chips 22 fixed thereto are engaged with the body 1, the chip 22 is aligned with the heat conducting member 23, and under the effect of a rebound force of the elastic member 24, the chip 22 can always be in tight and stable fit with the heat conducting member 23 so as to transfer heat. Heat generated by the PCB 21 and the chip 22 during operation is first transferred to the heat conducting silicone grease, then the heat conducting silicone grease transfers the heat generated by the chip 22 to the heat conducting member 23 and the heat dissipating member 25, such that the heat is transferred to the cooling chamber 3 and efficiently dissipated by the cooling liquid.

With the above arrangement, a pressure with which the heat conducting member 23 tightly abuts against the surface of the chip 22 can be ensured to reach a stable and balanced state by means of the rebound force of the elastic member 24, so as to effectively reduce the thermal resistance and improve the overall heat dissipation effect. In addition, the occurrence of a large assembly tolerance between the chip 22 and the heat conducting member 23 affecting the heat dissipation effect of the PCB 21 and the chip 22 is avoided, and a pressure on the chip 22 due to the large tolerance can also be reduced, thereby improving the heat dissipation efficiency of the chip 22, prolonging the service life of the chip 22, and enabling the chip 22 to be operated and used stably for a long time.

It should be noted that although the body 1 shown in FIG. 1 is a cuboid, this is merely a schematic illustration, the shape of the body 1 can be designed according to the shape of the PCB 21, the shape of a workspace, etc. For example, if the PCB is circular, the body may be a cylinder; and if the workspace of the PCB is a specially shaped space, the body can be correspondingly designed to be specially shaped so as to facilitate the installation of a PCB assembly in the specially shaped space.

The above configuration of the elastic member 24 is merely a preferred configuration, and in another feasible installation, the elastic member 24 may also be an elastic diaphragm, or the springs can be replaced by a bellows, as long as the chip 22 can always be in tight contact with the heat conducting member 23.

It should be noted that the above configuration of the heat dissipating member 25 is merely a preferred configuration, and in practical applications, those skilled in the art may use heat dissipating fins for heat dissipation, or use both of the heat pipes and heat dissipating fins for heat dissipation. In another feasible installation, the heat dissipating member may also be a heat sink with a fan.

The above cooling chamber 3 has merely an exemplary configuration, and in practical applications, a heat generating module can be cooled and dissipated by cooling fins, which may be made of a metal material such as copper or aluminum.

It should also be noted that, in other feasible embodiments, the cooling chamber 3 and the heat dissipating member 25 according to the above embodiments may not be provided.

The controller provided in the embodiments may be applied to a vehicle or other electronic device and can achieve beneficial effects of the PCBA module according to any one of the above embodiments, which will not be described in detail herein.

Heretofore, the technical solutions of the disclosure have been described with reference to the preferred implementations shown in the accompanying drawings. However, those skilled in the art can readily understand that the scope of protection of the disclosure is apparently not limited to these specific implementations. Without departing from the principles of the disclosure, those skilled in the art may make equivalent changes or replacements to related technical features. The technical solutions obtained after these changes or replacements fall within the scope of protection of the disclosure.

## Claims

1. A controller, comprising a body and a PCBA module arranged on the body, the PCBA module comprising a PCB and a chip fixed on a surface of the PCB, a heat conducting member capable of moving in a direction perpendicular to the surface of the PCB being provided between the chip and the body, an elastic member being provided between the heat conducting member and the body, the heat conducting member being connected to a heat dissipating member, and in an installed state, the chip abutting against a first side of the heat conducting member, and the elastic member abutting against the body at one end and abutting against a second side of the heat conducting member at the other end.

2. The controller according to claim **1,** wherein the elastic member is a plurality of springs uniformly arranged between the heat conducting member and the body.

3. The controller according to claim **1,** wherein a layer of heat conducting material is provided between the first side of the heat conducting member and the chip.

4. The controller according to claim **1,** wherein the elastic member is a bellows.

5. The controller according to claim **1,** wherein a cooling chamber is provided inside the body, the body is provided with an inlet and an outlet that are in communication with the cooling chamber, and the inlet, the cooling chamber, and the outlet form a cooling channel for circulation of a cooling liquid.

6. The controller according to claim 5, wherein a heat conducting spacer is provided inside the cooling chamber.

7. The controller according to any one of claims 1 to 6, wherein the heat dissipating member comprises a heat pipe.

8. The controller according to claim 7, wherein the heat pipe has one side connected to the heat conducting member and the other side abutting against the body.

9. The controller according to claim 7, wherein the heat pipe is annular, and one side of the heat pipe is welded to the second side of the heat conducting member, and a part of the other side of the heat pipe is welded to the body.

10. The controller according to claim **1,** wherein a guide structure is provided on the body and is configured to define a direction of movement of the heat conducting member.
